# EUROPÄISCHE PATENTANMELDUNG

(11) **EP 1 821 341 A1**
(43) Veröffentlichungstag der Anmeldung: **22.08.2007**
(21) Anmeldenummer: 07101947.5
(22) Anmeldetag: 08.02.2007
(51) Int. Cl.: H01L 21/603, H01L 21/607, H01L 41/047, H01L 25/065

(54) **Elektrische Anordnung mit einer Drahtverbindungsanordnung und Verfahren zum Herstellen einer derartigen elektrischen Anordnung**

(30) Priorität: 16.02.2006 DE 102006007306
(71) Anmelder: SIEMENS AKTIENGESELLSCHAFT, 80333 München (DE)
(72) Erfinder: Gohlke, Silvia, 93049, Regensburg (DE); Kraus, Sieglinde, 93049, Regensburg (DE); Rappl, Hans, 93152, Nittendorf (DE); Rauscher, Gunther, 94550, Künzing (DE)

(57) **Zusammenfassung**

Die vorliegende Erfindung beschreibt eine elektrische Anordnung mit einem ersten, elektrisch leitenden Kontaktpunkt (10) und einem zweiten, elektrisch leitenden Kontaktpunkt (20), wobei der erste und der zweite Kontaktpunkt in einem Abstand (x) zueinander angeordnet sind, und über eine Drahtverbindungsanordnung (30) miteinander elektrisch verbunden sind, wobei die Drahtverbindungsanordnung (30) durch zumindest zwei Drahtverbindungen (31-1, 31-2, .., 31-n-1, 31-n) gebildet ist, die jeweils ein erstes Ende (32-1, 32-1, .., 32-n-1, 32-n) und ein zweites Ende (33-1, 33-2, .., 33-n-1, 33-3) aufweisen, und das erste Ende einer Drahtverbindung (30-2, ..,30-n) mit dem zweiten Ende einer vorhergehenden Drahtverbindung (30-1, ..,30-n-1) einen direkten Kontakt zueinander aufweisen.

## Beschreibung

Die Erfindung betrifft eine elektrische Anordnung mit einem ersten, elektrisch leitenden Kontaktpunkt und einem zweiten, elektrisch leitenden Kontaktpunkt, wobei der erste und der zweite Kontaktpunkt in einem Abstand zueinander angeordnet sind, und über eine Drahtverbindungsanordnung miteinander elektrisch leitend verbunden sind. Die Erfindung betrifft ferner ein Verfahren zum Herstellen einer derartigen elektrischen Anordnung.

Die Herstellung von elektrisch leitenden Verbindungen zwischen zwei Kontaktpunkten unter Verwendung eines sog. Bonddrahts ist in der Mikroelektronik weit verbreitet. Bonddrähte werden beispielsweise zum elektrischen Kontaktieren eines Halbleiterchips mit einem Substrat verwendet. Dabei kann die Zuverlässigkeit einer Drahtverbindung insbesondere bei der Überbrückung von langen Abständen gering sein, insbesondere wenn die elektrische Anordnung Umwelteinflüssen, wie z.B. Vibrationen, ausgesetzt ist. Zur Reduktion der Fehleranfälligkeit werden deshalb häufig Bonddrähte mit dickerem Durchmesser eingesetzt. Einhergehend mit höheren Materialkosten müssen die elektrisch leitenden Kontaktpunkte zur Kontaktierung mit einem solchen Bonddraht größer ausgebildet werden, so dass die elektrische Anordnung einen insgesamt größeren Platzbedarf hat. Ein solches Vorgehen ist jedoch insbesondere bei der elektrischen Kontaktierung von Halbleiterbauelementen nicht möglich.

Die Aufgabe der vorliegenden Erfindung besteht deshalb darin, eine elektrische Anordnung anzugeben, mit der die oben aufgezeigten Nachteile vermieden werden können.

Eine weitere Aufgabe der vorliegenden Erfindung besteht darin, ein Verfahren zum Fertigen einer solchen elektrischen Anordnung anzugeben.

Diese Aufgaben werden durch eine erfindungsgemäße elektrische Anordnung mit den Merkmalen des Patentanspruches 1 sowie durch ein erfindungsgemäßes Verfahren gemäß den Merkmalen des Patentanspruches 11 gelöst. Vorteilhafte Ausgestaltungen ergeben sich jeweils aus den abhängigen Patentansprüchen.

Bei einer erfindungsgemäßen elektrischen Anordnung mit einem ersten, elektrisch leitenden Kontaktpunkt und einem zweiten, elektrisch leitenden Kontaktpunkt, wobei der erste und der zweite Kontaktpunkt in einem Abstand zueinander angeordnet sind und über eine Drahtverbindungsanordnung miteinander elektrisch leitend verbunden sind, ist die Drahtverbindungsanordnung durch zumindest zwei Drahtverbindungen gebildet, die jeweils ein erstes Ende und ein zweites Ende aufweisen, und wobei das erste Ende einer Drahtverbindung mit dem zweiten Ende einer vorhergehenden Drahtverbindung einen direkten Kontakt zueinander aufweist.

Hierdurch kann die Drahtverbindungsanordnung in Form einer Kette mehrerer einzelner Drahtverbindungen mit jeweils optimierter Länge ausgebildet werden, wobei prinzipiell eine beliebige Anzahl an einzelnen Drahtverbindungen vorgesehen sein kann. Die Verwendung einer derartigen Drahtverbindungsanordnung vermeidet das Vorsehen einer einzigen Drahtverbindung zwischen zwei weit entfernten Kontaktpunkten. Hierdurch kann eine elektrische Anordnung bereitgestellt werden, welche eine höhere Zuverlässigkeit aufweist und insbesondere in Anwendungen einsetzbar ist, welche starken Umwelteinflüssen, wie z.B. Vibrationen, ausgesetzt sind. Ferner müssen zur Überwindung größerer Abstände zwischen dem ersten und dem zweiten Kontaktpunkt keine in ihrem Durchmesser unüblichen Drahtverbindungen eingesetzt werden. Dies erleichtert einerseits die Fertigung, da Drahtverbindungen mit üblicherweise verwendeten Querschnitten eingesetzt werden können. Darüber hinaus benötigen der erste und der zweite Kontaktpunkt im Vergleich zu herkömmlichen Anordnungen keinen größeren Platzbedarf.

Eine besonders gute Zuverlässigkeit ist dann gegeben, wenn das erste Ende der Drahtverbindung mit dem zweiten Ende der benachbarten, vorhergehenden Drahtverbindung stoffschlüssig verbunden ist. Zur Herstellung einer stoffschlüssigen Verbindung kann dabei im Prinzip jedes herkömmliche, bekannte Verbindungsverfahren eingesetzt werden.

Eine besonders einfache Herstellung der Drahtverbindungsanordnung, welche überdies einen geringen Platzbedarf aufweist, ist dann möglich, wenn gemäß einer weiteren Ausführungsform das erste Ende auf dem zweiten Ende aufgesetzt ist. Dabei ist es insbesondere zweckmäßig, wenn das erste Ende einen Nagelkopf, insbesondere einen Nailhead, und das zweite Ende eine Keilfläche, insbesondere ein Wedge, darstellt, wobei das erste Ende mittels eines Thermokompressions-Bondverfahrens auf dem zweiten Ende aufgesetzt ist. Mit der dabei durchgeführten Kettenbondung kann ohne Platzverlust eine beliebig lange, elektrisch leitende Bondverbindung zwischen dem ersten und dem zweiten Kontaktpunkt hergestellt werden. Die dabei zugrunde liegende Vorgehensweise besteht darin, die jeweils folgende Bondverbindung, die dem Fachmann auch unter dem Begriff des Bond Loops bekannt ist, auf das Ende der vorhergehenden Drahtverbindung (Bond Loop) zu setzen.

Eine besonders stabile Anordnung ergibt sich dann, wenn der erste und der zweite Kontaktpunkt auf einer Substratanordnung ausgebildet sind und elektrische Anschlusskontakte der Anordnung ausbilden, und das erste oder das zweite Ende miteinander verbundener Drahtverbindungen auf einem weiteren Kontaktpunkt der Substratanordnung angeordnet sind und einen Zwischenkontakt ausbilden. Die Kettenbondung zwischen dem ersten und dem zweiten Kontaktpunkt wird damit über Stützpunkte darstellende Zwischenkontakte realisiert. Die Abstände zwischen dem ersten oder zweiten Kontaktpunkt und einem weiteren Kontaktpunkt oder zwischen zwei weiteren Kontaktpunkten können hinsichtlich einer maximalen Zuverlässigkeit der Bondverbindung gewählt werden. Der Vorteil dieser Vorgehensweise besteht insbesondere darin, dass die weiteren Kontaktpunkte auf der Substratanordnung beispielsweise nicht mit einer elektrischen Leiteranordnung kontaktiert zu werden brauchen, wodurch eine hohe Flexibilität beim Erstellen des Layouts, z.B. auf der Substratanordnung, ermöglicht ist. Insbesondere ist es hierdurch möglich, den ersten und den zweiten Kontaktpunkt hinsichtlich eines Leiterbahnlayouts optimiert anzuordnen, ohne dabei den Abstand zwischen dem ersten und zweiten Kontaktpunkt berücksichtigen zu müssen.

Gemäß einer weiteren Ausführungsform ist zumindest ein Substratabschnitt der Substratanordnung im Bereich des oder der Zwischenkontakte elektrisch isolierend. Der im Bereich des Zwischenkontakts angeordnete weitere Kontaktpunkt hat damit lediglich die Aufgabe, eine mechanische Verbindung der in elektrischem Kontakt miteinander verbundenen Drahtverbindungen mit der Substratanordnung herzustellen.

Gemäß einer weiteren Ausführungsform ist zumindest ein Substratabschnitt der Substratanordnung im Bereich des oder der Zwischenkontakte elektrisch leitend, wobei der weitere Kontakt mit der Substratanordnung leitend geschalten ist. Die Erfindung ermöglicht damit nicht nur die Überbrückung großer Abstände zwischen einem ersten und einem zweiten Kontaktpunkt, sondern auch alternative Verschaltungstechniken, die üblicherweise unter Verwendung beispielsweise von Lot- und Drahtverbindungen hergestellt werden.

Gemäß einer weiteren Ausführungsform ist die Substratanordnung durch ein Halbleiterelement, das auf einem Träger angeordnet ist, ausgebildet, wobei der erste Anschlusskontakt auf dem Halbleiterelement und der zweite Anschlusskontakt auf dem Träger ausgebildet ist.

Gemäß einer anderen Ausgestaltung ist die Substratanordnung durch eine Anzahl an übereinander gestapelten Elementen, insbesondere Festkörperaktoren, gebildet, wobei die übereinander gestapelten Elemente über zwei Drahtverbindungsketten parallel geschalten sind, welche aus jeweils einer Anzahl an miteinander in direktem Kontakt stehenden Drahtverbindungen gebildet sind. Bei der hier beschriebenen elektrischen Anordnung wird das Prinzip der Drahtkettenverbindung zur Kontaktierung, z.B. eines Multilayer-Piezostacks, herangezogen.

Besonders vorteilhaft ist es, wenn die Drahtverbindungen und/oder die Kontaktpunkte und/oder der oder die weiteren Kontaktpunkte zumindest eine Oberfläche aus Gold aufweisen. Hierdurch lässt sich eine optimale mechanische Verbindung zwischen den Fügepartnern herstellen, so dass eine maximale mechanische Belastbarkeit der resultierenden elektrischen Anordnung erreicht ist.

Mit dem erfindungsgemäßen Verfahren zum Herstellen einer elektrischen Anordnung, die wie oben beschrieben ausgebildet ist, sind die gleichen Vorteile verbunden, wie vorstehend erläutert.

Ein erfindungsgemäßes Verfahren zum Herstellen einer derartigen Anordnung umfasst die folgenden Schritte:
a) Bereitstellen einer Substratanordnung mit einem ersten Kontaktpunkt, einem zweiten Kontaktpunkt und zumindest einem weiteren Kontaktpunkt;
b) Herstellen einer, insbesondere stoffschlüssigen, Verbindung zu dem ersten Kontaktpunkt mit einer Drahtbondvorrichtung, indem das erste Ende einer ersten Drahtverbindung mit dem ersten Kontaktpunkt, insbesondere stoffschlüssig, verbunden wird;
c) Herstellen einer, insbesondere stoffschlüssigen, Verbindung zu dem weiteren Kontaktpunkt mit der Drahtbondvorrichtung, indem das zweite Ende der ersten Drahtverbindung mit dem weiteren Kontaktpunkt, insbesondere stoffschlüssig, verbunden wird, wobei das mit dem weiteren Kontaktpunkt verbundene zweite Ende eine von dem weiteren Kontaktpunkt abgewandte Keilfläche aufweist;
d) Herstellen einer, insbesondere stoffschlüssigen, Verbindung zu dem zweiten Ende der ersten Drahtverbindung mit der Drahtbondvorrichtung, indem das erste Ende einer zweiten Drahtverbindung mit der Keilfläche der ersten Drahtverbindung, insbesondere stoffschlüssig, verbunden wird;
e) Herstellen einer, insbesondere stoffschlüssigen, Verbindung zu dem zweiten Kontaktpunkt mit der Drahtbondvorrichtung, indem das zweite Ende der zweiten Drahtverbindung mit dem zweiten Kontaktpunkt, insbesondere stoffschlüssig, verbunden wird.

Gemäß einer Ausführungsform ist vorgesehen, dass zur Herstellung einer Kettenverbindung mit mehr als zwei Drahtverbindungen die Schritte c) und d) wiederholt werden.

Das im Rahmen des erfindungsgemäßen Verfahrens zugrunde liegende Prinzip besteht darin, das jeweils folgende erste Ende der Drahtverbindung (Bond Loop) auf das zweite Ende der vorhergehenden Drahtverbindung (Bond Loop) zu setzen. Aufgrund der identischen Materialen der beiden Drahtverbindungen und deren stoffschlüssigen Verbindung wird ein optimaler mechanischer Kontakt hergestellt, der auch starken Umwelteinflüssen standhält. Darüber hinaus wird, verglichen mit dem herkömmlichen Bondverfahren, kein zusätzlicher Platz benötigt, da die durch das zweite Ende der vorhergehenden Drahtverbindung bereitgestellte Keilfläche als Bondfläche für das erste Ende der nachfolgenden Drahtverbindung dient.

Es ist weiter bevorzugt, wenn der Schritt des Verbindens einer der folgenden Kontaktpartner durch Mikroverschweißen erfolgt:
- das erste Ende der Drahtverbindung mit dem ersten Kontaktpunkt oder dem zweiten Ende der vorhergehenden Drahtverbindung,
- das zweite Ende der Drahtverbindung mit dem weiteren Kontaktpunkt oder dem zweiten Kontaktpunkt.

Weitere Vorteile und Merkmale der Erfindung werden nachfolgend anhand der Figuren näher erläutert. Es zeigen:
- Fig. 1: einen Schnitt durch ein erstes Ausführungsbeispiel einer erfindungsgemäßen elektrischen Anordnung, welche durch einen auf einem Träger aufgebrachten Halbleiterchip gebildet ist,
- Fig. 2: eine Draufsicht auf die in Fig. 1 gezeigte elektrische Anordnung,
- Fig. 3: eine schematische Darstellung eines aus dem Stand der Technik bekannten Multilayer-Piezostacks, aus dem die elektrische Verschaltung erkenntlich wird,
- Fig. 4: das im Stand der Technik bekannte Kontaktierverfahren für den in Fig. 3 dargestellten Multilayer-Piezostack, und
- Fig. 5: eine schematische Querschnittsdarstellung der elektrischen Kontaktierung eines Multilayer-Piezostacks gemäß der vorliegenden Erfindung.

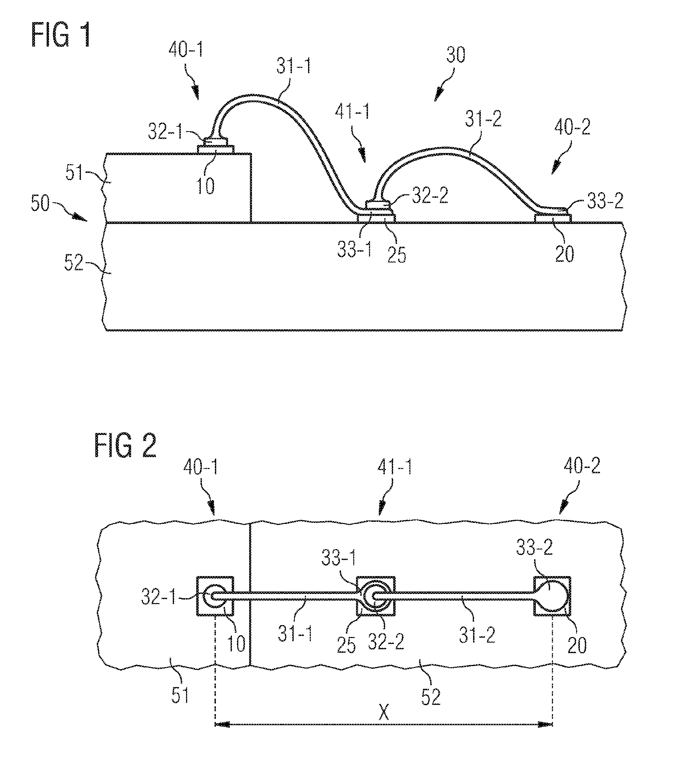

Unter Bezugnahme auf die Fig. 1 und 2 wird nachfolgend ein erstes Ausführungsbeispiel einer erfindungsgemäßen elektrischen Anordnung beschrieben. Eine Substratanordnung 50 umfasst einen aus einem isolierenden Material bestehenden Träger 52, auf dem ein Halbleiterelement 51, z.B. durch Löten, Kleben oder andere beliebige Weise, aufgebracht ist. Das Halbleiterelement 51 umfasst auf seiner von dem Träger 52 abgewandten Hauptfläche einen ersten Kontaktpunkt 10. Der erste Kontaktpunkt 10 kann z.B. in bekannter Weise aus einer Metallisierung bestehen. Ein zweiter Kontaktpunkt 20 ist auf dem Träger 52 aufgebracht. Der Kontaktpunkt 20 kann beispielsweise Teil einer in den Figuren nicht näher dargestellten Leiterzuganordnung sein. Eine elektrische Verbindung zwischen dem ersten und dem zweiten Kontaktpunkt 10, 20 ist durch eine Drahtverbindungsanordnung 30 hergestellt.

Die Drahtverbindungsanordnung 30 umfasst im vorliegenden Ausführungsbeispiel zwei Drahtverbindungen 31-1 und 31-2, welche auch als Bonddrähte bezeichnet sind. Bevorzugt, aber nicht notwendiger Weise, sind die Drahtverbindungen 31-1, 31-2 sowie die Kontaktpunkte 10, 20 und ein weiterer Kontaktpunkt 25, welcher im Beispiel ebenfalls auf dem Träger 52 aufgebracht und zwischen dem ersten und zweiten Kontaktpunkt 10, 20 angeordnet ist, aus Gold oder einer Goldlegierung.

Die Drahtverbindung 31-1 weist ein erstes Ende 32-1 und ein zweites Ende 33-1 auf. In entsprechender Weise umfasst die zweite Drahtverbindung 31-2 ein erstes Ende 32-2 und ein zweites Ende 33-2. Die Drahtverbindungen 31-1 und 31-2 werden unter Verwendung eines herkömmlichen Thermokompressions-Bondverfahrens aufgebracht. Dementsprechend werden die ersten Enden der Drahtverbindungen auch als Nailheads und die zweiten Enden der Drahtverbindungen als Keilflächen oder Wedges bezeichnet.

Das erste Ende 32-1 der ersten Drahtverbindung 31-1 wird auf die zu kontaktierende Fläche, den ersten Kontaktpunkt 10, gepresst. Die elektrische Verbindung entsteht, indem die Drahtverbindung, z.B. mittels eines kurzen Ultraschallpulses, mit dem ersten Kontaktpunkt 10 mikroverschweißt wird. Anschließend wird eine Kapillare oder Nadel zu dem weiteren Kontaktpunkt 25 bewegt, wobei Bonddraht durch die Nadelspitze oder Kapillare nachgeführt wird. Der Draht wird an dem weiteren Kontaktpunkt 25 angepresst und mit diesem, z.B. mittels eines Ultraschallpulses, verbunden, der den Draht diesmal zudem durchtrennt. Dabei entsteht die Keilfläche am zweiten Ende 33-1 der ersten Drahtverbindung, die in etwa die Abmaße des weiteren Kontaktpunkts 25 aufweist. Die Keilfläche am zweiten Ende 33-1 der ersten Drahtverbindung 31-1 bildet die Kontaktfläche für die zweite Drahtverbindung 31-2. Dementsprechend wird das erste Ende 32-2 der zweiten Drahtverbindung 31-2 auf die Keilfläche am zweiten Ende der ersten Drahtverbindung gepresst und mit dieser, z.B. durch einen kurzen Ultraschallpuls, mikroverschweißt. Die weitere Verbindung des zweiten Endes 33-2 der zweiten Drahtverbindung 31-2 entsteht, wie vorher beschrieben.

Durch Wiederholung des beschriebenen Vorgehens lassen sich beliebig lange Verbindungen zwischen dem ersten und dem zweiten Kontaktpunkt 10, 20 herstellen. Das erfindungsgemäße Vorgehen eignet sich insbesondere dann, wenn der zwischen dem ersten und zweiten Kontaktpunkt bestehende Abstand x eine solche Größe aufweist, dass eine Bondverbindung mit einer einzigen Drahtverbindung entweder nicht möglich ist oder die Gefahr einer Beschädigung der Drahtverbindung und insbesondere der Verbindungen mit den Kontaktpunkten aufgrund von äußeren Einflüssen besteht.

Durch die Anordnung des ersten Endes einer Drahtverbindung auf dem zweiten Ende der vorherigen Drahtverbindung entsteht ein geringerer Platzbedarf als bei einem herkömmlichen Verbindungsverfahren, bei dem die zwei Enden der ersten und der zweiten Drahtverbindung jeweils auf eigenen Kontaktpunkten aufgesetzt werden bzw. zur Überbrückung der Distanz zwischen erstem und zweitem Kontaktpunkt 10, 20 nur eine, dann dickere, Drahtverbindung verwendet wird. Die Zuverlässigkeit gegenüber einer "langen" Drahtverbindung wird durch Standard-Drahtverbindungen erhöht. Ein weiterer Vorteil besteht darin, dass man auf unterschiedlichen Oberflächen Verbindungen herstellen kann, wodurch auch kostengünstige Träger einsetzbar sind. Darüber hinaus sind die Freiheitsgrade bei der Erstellung der Leiterzuggeometrie, insbesondere auf dem Träger 52, erhöht, da der Abstand zwischen dem ersten und dem zweiten Kontaktpunkt 20, welche im vorliegenden Ausführungsbeispiel Anschlusskontakte 40-1 und 40-2 ausbilden, beliebig gewählt werden kann. Die elektrische Kontaktierung erfolgt unter Verwendung eines oder mehrerer Zwischenkontakte 41-1, die an dazu geeigneten Stellen ohne (notwendige aber mögliche) weitere elektrische Anbindung, auf dem Träger 52 platziert werden können.

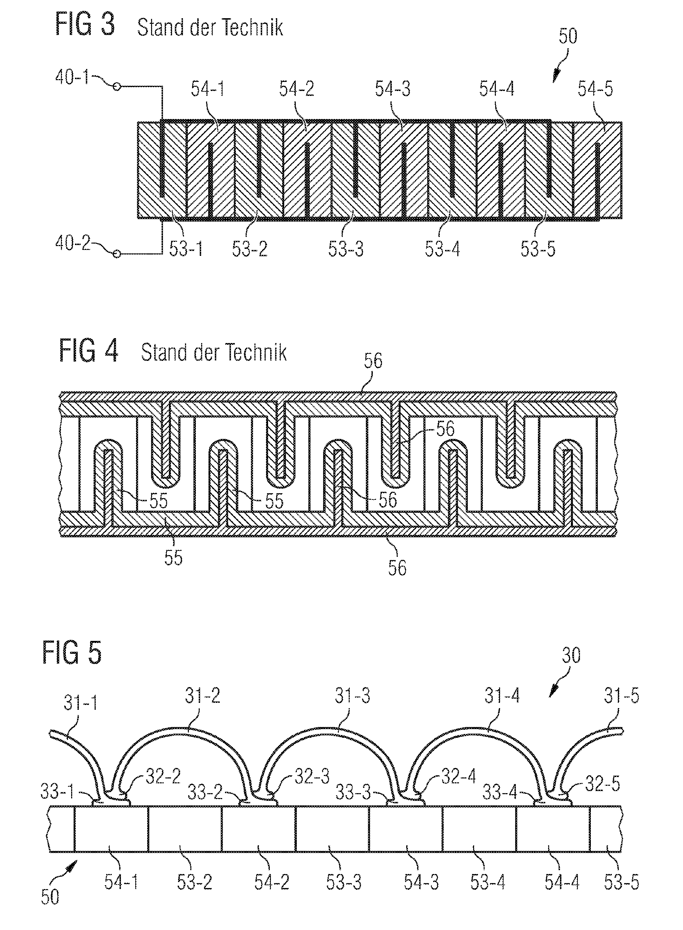

Das erfindungsgemäße Vorgehen lässt sich auch zur Kontaktierung z.B. eines Multilayer-Piezostacks einsetzen. Dieses zweite Ausführungsbeispiel einer erfindungsgemäßen elektrischen Anordnung wird unter Bezugnahme auf die Fig. 3 bis 5 näher erläutert. Die Fig. 3 und 4 zeigen dabei den prinzipiellen Aufbau eines Multilayer-Piezostacks aus einer Mehrzahl an übereinander gestapelten Festkörperaktoren. Diese sind im Ausführungsbeispiel mit den Bezugszeichen 53-i, 54-i, wobei i = 1 bis 5 (oder allgemein n), gekennzeichnet. Die einzelnen Festkörperaktoren sind elektrisch parallel zueinander verschaltet. Die Elemente 53-i sind herkömmlicherweise über eine Lot-Drahtverbindung mit einem Anschlusskontakt 40-2 verbunden. Die Elemente bzw. Festkörperaktoren 54-i sind ebenfalls über eine Lot-Drahtverbindung mit dem Anschlusskontakt 40-1 verbunden. Drähte 56 sind dabei in der in Fig. 4 gezeigten Weise über eine Lotpaste miteinander und mit dem jeweiligen Anschlusskontakt verbunden. Nachteilig bei diesem Vorgehen sind sog. Auflöterscheinungen, worunter defekte Lötverbindungen aufgrund thermisch nicht aneinander angepasster Materialien verstanden werden. Ein weiteres Problem ist das Ablegieren der Lötoberfläche (Paste), verursacht durch unterschiedliche Materialien der Lötpaste und des Drahtes.

Demgegenüber zeigt Fig. 5 eine elektrische Kontaktierung eines in Fig. 3 gezeigten Multilayer-Piezostacks über eine erfindungsgemäße Drahtverbindungsanordnung 30 unter Verwendung einer Kettenbondung. Wie aus der Figur ohne weiteres ersichtlich ist, sind die Festkörperaktoren 54-i jeweils durch eine Drahtverbindung 31-i miteinander verbunden. Der Übersichtlichkeit halber ist die, die Festkörperaktoren 53-i elektrisch miteinander verbindende, Drahtkette nicht dargestellt. Dabei wird das vorher beschriebene Prinzip der Kettenbondung eingesetzt, bei dem das erste Ende einer Drahtverbindung auf das zweite Ende einer vorhergehenden Drahtverbindung aufgesetzt ist. Dabei wird, wie ebenfalls in Verbindung mit Fig. 1 und 2 beschrieben, bevorzugt ein Thermokompressions-Bondverfahren eingesetzt.

Vorteil dieser Verbindungstechnologie ist, dass die Temperaturbelastbarkeit der Bondverbindungen deutlich höher als die der Lötverbindungen ist. Ferner spielt die bei einer Lötverbindung auftretende Alterung des Verbindungskontakts keine Rolle. Das vorgestellte Verbindungsverfahren ermöglicht zudem die Verwendung alternativer Oberflächen, insbesondere der Kontaktpunkte bzw. weiteren Kontaktpunkte, wodurch sich Kostenvorteile erzielen lassen.

## Patentansprüche

1. Elektrische Anordnung mit einem ersten, elektrisch leitenden Kontaktpunkt (10) und einem zweiten, elektrisch leitenden Kontaktpunkt (20), wobei der erste und der zweite Kontaktpunkt
- in einem Abstand (x) zueinander angeordnet sind, und
- über eine Drahtverbindungsanordnung (30) miteinander elektrisch verbunden sind,
wobei die Drahtverbindungsanordnung (30) durch zumindest zwei Drahtverbindungen (31-1, 31-2, .., 31-n-l, 31-n) gebildet ist, die jeweils ein erstes Ende (32-1, 32-1, .., 32-n-l, 32-n) und ein zweites Ende (33-1, 33-2, .., 33-n-1, 33-3) aufweisen, und das erste Ende einer Drahtverbindung (30-2, ..,30-n) mit dem zweiten Ende einer vorhergehenden Drahtverbindung (30-1, ..,30-n-1) einen direkten Kontakt zueinander aufweisen.

2. Anordnung nach Anspruch 1,
**dadurch gekennzeichnet, dass**
das erste Ende der Drahtverbindung (30-2, ..,30-n) mit dem zweiten Ende der benachbarten, vorhergehenden Drahtverbindung (30-1, ..,30-n-1) stoffschlüssig verbunden ist.

3. Anordnung nach Anspruch 1 oder 2,
**dadurch gekennzeichnet, dass**
das erste Ende (32-1, 32-1, .., 32-n-1, 32-n) auf dem zweiten Ende (33-1, 33-2, .., 33-n-1, 33-3) aufgesetzt ist.

4. Anordnung nach Anspruch 3,
**dadurch gekennzeichnet, dass**
das erste Ende einen Nagelkopf, insbesondere einen Nailhead, und das zweite Ende eine Keilfläche, insbesondere ein Wedge, darstellt, wobei das erste Ende (32-1, 32-1, .., 32-n-l, 32-n) mittels eines Thermokompressions-Bondverfahrens auf dem zweiten Ende (33-1, 33-2, .., 33-n-l, 33-3) aufgesetzt ist.

5. Anordnung nach einem der vorherigen Ansprüche,
**dadurch gekennzeichnet, dass**
der erste und der zweite Kontaktpunkt (10, 20) auf einer Substratanordnung (50) ausgebildet sind und elektrische Anschlusskontakte (40-1, 40-2) der Anordnung ausbilden, und das erste oder das zweite Ende miteinander verbundener Drahtverbindungen (31-1, 31-2, .., 31-n-1, 31-n) auf einem weiteren Kontaktpunkt (25) der Substratanordnung (50) angeordnet sind und einen Zwischenkontakt (41-1, 41-2, .., 41-n-1) ausbilden.

6. Anordnung nach Anspruch 5,
**dadurch gekennzeichnet, dass**
zumindest ein Substratabschnitt der Substratanordnung (50) im Bereich des oder der Zwischenkontakte (40-1, 40-2, .., 40-n-1) elektrisch isolierend ist.

7. Anordnung nach Anspruch 5,
**dadurch gekennzeichnet, dass**
zumindest ein Substratabschnitt der Substratanordnung (50) im Bereich des oder der Zwischenkontakte (40-1, 40-2, .., 40-n-1) elektrisch leitend ist, wobei der weitere Kontakt mit der Substratanordnung (50) leitend geschalten ist.

8. Anordnung nach einem der Ansprüche 5 bis 7,
**dadurch gekennzeichnet, dass**
die Substratanordnung (50) durch ein Halbleiterelement (51), das auf einem Träger (52) angeordnet ist, ausgebildet ist, wobei der erste Anschlusskontakt (10) auf dem Halbleiterelement (51) und der zweite Anschlusskontakt (20) auf dem Träger (52) ausgebildet ist.

9. Anordnung nach einem der Ansprüche 5 bis 7,
**dadurch gekennzeichnet, dass**
die Substratanordnung (50) durch eine Anzahl an übereinander gestapelten Elementen (53-1, 54-1, 53-2, 54-2, .., 52-n, 54-n), insbesondere Festkörperaktoren, gebildet ist, wobei die übereinander gestapelten Elemente über zwei Drahtverbindungsketten parallel geschalten sind, welche aus jeweils einer Anzahl an miteinander in direktem Kontakt stehenden Drahtverbindungen gebildet sind.

10. Anordnung nach einem der vorherigen Ansprüche,
**dadurch gekennzeichnet, dass**
die Drahtverbindungen und/oder die Kontaktpunkte (10, 20) und/oder der oder die weiteren Kontaktpunkte (25) zumindest eine Oberfläche aus Gold aufweisen.

11. Verfahren zum Herstellen einer elektrischen Anordnung nach einem der vorherigen Ansprüche mit den Schritten:
a) Bereitstellen einer Substratanordnung (50) mit einem ersten Kontaktpunkt (10), einem zweiten Kontaktpunkt (20) und zumindest einem weiteren Kontaktpunkt (25);
b) Herstellen einer, insbesondere stoffschlüssigen, Verbindung zu dem ersten Kontaktpunkt (10) mit einer Drahtbondvorrichtung, indem das erste Ende (32-1) einer ersten Drahtverbindung (30-1) mit dem ersten Kontaktpunkt (10), insbesondere stoffschlüssig, verbunden wird,
c) Herstellen einer, insbesondere stoffschlüssigen, Verbindung zu dem weiteren Kontaktpunkt (25) mit der Drahtbondvorrichtung, indem das zweite Ende (33-1) der ersten Drahtverbindung (31-1) mit dem weiteren Kontaktpunkt (25), insbesondere stoffschlüssig, verbunden wird, wobei das mit dem weiteren Kontaktpunkt (25) verbundene zweite Ende (33-1) eine von dem weiteren Kontaktpunkt (25) abgewandte Keilfläche () aufweist;
d) Herstellen einer, insbesondere stoffschlüssigen, Verbindung zu dem zweiten Ende (33-1) der ersten Drahtverbindung (31-1) mit der Drahtbondvorrichtung, indem das erste Ende (32-2) einer zweiten Drahtverbindung (31-2) mit der Keilfläche der ersten Drahtverbindung (31-1), insbesondere stoffschlüssig, verbunden wird,
e) Herstellen einer, insbesondere stoffschlüssigen, Verbindung zu dem zweiten Kontaktpunkt (20) mit der Drahtbondvorrichtung, indem das zweite Ende (33-2) der zweiten Drahtverbindung (31-2) mit dem zweiten Kontaktpunkt (20), insbesondere stoffschlüssig, verbunden wird.

12. Verfahren nach Anspruch 11,
**dadurch gekennzeichnet, dass**
zur Herstellung einer Drahtkettenverbindung mit mehr als zwei Drahtverbindungen die Schritte c) und d) wiederholt werden.

13. Verfahren nach Anspruch 11 oder 12,
**dadurch gekennzeichnet, dass**
der Schritt des Verbindens einer der folgenden Kontaktpartner durch Mikroverschweißen erfolgt:
- das erste Ende der Drahtverbindung mit dem ersten Kontaktpunkt (10) oder dem zweiten Ende der vorhergehenden Drahtverbindung,
- das zweite Ende der Drahtverbindung mit dem weiteren Kontaktpunkt (25) oder dem zweiten Kontaktpunkt (20).
